# EUROPÄISCHE PATENTSCHRIFT

(11) **EP 0 419 767 B1**
(45) Veröffentlichungstag und Bekanntmachung des Hinweises auf die Patenterteilung: **24.11.1993**
(21) Anmeldenummer: 90111215.1
(22) Anmeldetag: 13.06.1990
(51) Int. Cl.: H01L 21/302, G02B 6/42, G02B 6/12, G02B 6/26

(54) **Verfahren zur Herstellung eines Körpers aus Silizium**
Method for manufacturing a Silicon body
Procédé de fabrication d'un corps en silicium

(30) Priorität: 29.09.1989 DE 3932654
(43) Veröffentlichungstag der Anmeldung: 03.04.1991
(73) Patentinhaber: SIEMENS AKTIENGESELLSCHAFT, 80333 München (DE)
(72) Erfinder: Stein, Karl-Ulrich, Dr., D-8025 Unterhaching (DE)

(56) Entgegenhaltungen:
- EP-A- 0 136 050
- EP-A- 0 154 431
- DE-A- 3 829 906
- US-A- 4 411 060
- IEEE TRANSACTIONS ON ELECTRON DEVICES. vol. ED-25, no. 10, Oktober 1978, NEW YORK US Seiten 1178 - 1185; Ernest BASSOUS: "Fabrication of novel three-dimensional microstructures by the anisotropic etching of (100) and (110) Silicon"
- Conference record of the 16th. IEEE photovoltaic specialists conference 27 September 1982, SAN DIEGO CA. Seiten 1299 - 1303; Jack P. SALERNO et al.: "Growth and characterization of oriented GaAs bicrystal layers"

## Beschreibung

Die erfindung betrifft ein Verfahren zur Herstellung eines Körpers aus kristallinem Silizium.

Einkristallines Silizium, das durch Ätzen bearbeitet wird, ist ein zukunftsversprechendes Material für die Mikromechanik, die auch als Mikrosystemtechnik bezeichnet wird. Ihre Anwendungen befinden sich noch in den Anfängen. Ein wichtiger Anwendungsbereich sind Kupplungen und Stecker für Lichtwellenleiter-Bauelemente und -fasern.

Dabei macht man derzeit bereits von der sog. V-Nut-Technik Gebrauch, die auf Scheiben mit der Orientierung (100) mit anisotropem Ätzen hergestellt wird. Damit lassen sich insbesondere runde und zylindrische Körper, wie Kugellinsen und Fasern, justieren und fixieren. Sollen auch weitere Justierund Fixierhilfen auf der Scheibe erzeugt werden, könnte dies durch eine Kombination von anisotropem Ätzen mit geeignetem isotropem Ätzen auf (100)-Siliziummaterial geschehen.

In der Veröffentlichung von E. Bassous: "Fabrication of Novel Three-Dimensional Microstructures by the Anisotropic Etching of (100) and (110) Silicon" in IEEE Transactions on Electron Devices ED-25, 1178 bis 1185 (1978) sind Verfahren beschrieben, wie mittels anisotropen Ätzens in Siliziumkörpern Aussparungen, insbesondere v-förmige oder u-förmige Gräben, hergestellt werden können. Es werden dabei an die jeweiligen Aussparungen angepaßte Kristallorientierungen gewählt. Außerdem ist ein Verfahren zur Verbindung solcher Siliziumkörper beschrieben.

In der EP 0 136 050 ist ein Verfahren zum Verbinden einkristalliner Siliziumkörper beschrieben. Bei diesem Verfahren werden die miteinander zu verbindenden Flächen zunächst poliert, dann gereinigt und dann in unmittelbaren Kontakt miteinander gebracht. Ergänzend wird auf die Möglichkeit eines Temperprozesses hingewiesen.

In der US 4 411 060 ist ein Verfahren zur Herstellung mehrschichtiger Siliziumsubstrate beschrieben. Die Verbindung zweier Siliziumscheiben geschieht dabei dadurch, daß auf der einen Scheibe ein Siliziumoxidfilm hergestellt wird und die beiden Scheiben durch eine metallische Zwischenschicht und einen Temperschritt miteinander verbunden werden.

Aufgabe der vorliegenden Erfindung ist es, ein Verfahren zur Herstellung eines Körpers aus kristallinem Silizium anzugeben, bei dem unterschiedliche Aussparungen zum Befestigen von Glasfasern, optoelektronischen Komponenten und dergleichen vorhanden sind und diese Aussparungen alleine durch anisotropes Ätzen hergestellt werden können.

Diese Aufgabe wird mit dem Verfahren mit den Merkmalen des Anspruches 1 gelöst. Weitere Ausgestaltungen ergeben sich aus den abhängigen Ansprüchen.

Ein Anwendungsbeispiel der Erfindung ist in der Zeichnung dargestellt und wird in der nachfolgenden Beschreibung näher erläutert. Von den Figuren zeigen:

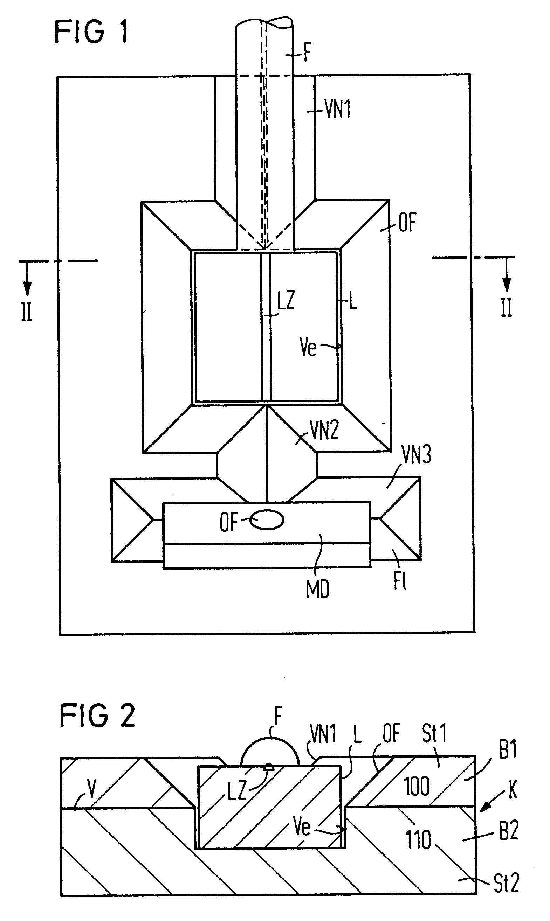

- Figur 1: eine Draufsicht auf das Anwendungsbeispiel, und
- Figur 2: einen Querschnitt durch das Beispiel nach Figur 1 längs der Schnittlinie II-II.

Bei dem in den Figuren dargestellten Anwendungsbeispiel sind auf einem Körper K aus kristallinem Silizium ein Laserchip L mit seitlichem Lichtaustritt, eine an die laseraktive Zone LZ dieses Laserchips L angekoppelte Lichtleitfaser F, beispielsweise eine Monomodefaser, und ein Monitordetektor MD mit Detektorfenster DF zur Uberwachung und/ oder Regelung der Ausgangsleistung des Chips L befestigt.

Der Körper K besteht beispielsweise aus einer oberen Scheibe Stl aus einkristallinem Silizium der Kristallorientierung (100) und aus einer unteren Scheibe St2 aus einkristallinem Silizium der Kristallorientierung (110), die beide flachseitig durch eine Verbindung V miteinander verbunden sind. Diese Verbindung V kann z. B. hergestellt werden, indem zwei Scheiben aus Silizium durch Tempern bei Temperaturen über 1000 °C direkt miteinander verbunden werden. Stattdessen können die Scheiben auch durch Tempern bei Temperaturen über 1000 °C über SiO₂ miteinander verbunden werden. Eine weitere Möglichkeit besteht darin, daß zwei Siliziumstücke durch ein siliziumkompatibles Glaslot, wie z. B. mit Phosphor dotiertes SiO₂, miteinander verbunden werden. Die Siliziumstücke können auch durch eine Metallottechnik miteinander verbunden werden, wobei z. B. ein Silizium-Metall-Eutektikum, insbesondere ein Silizium-Gold-Eutektikum, in Frage kommt. Stets werden die Siliziumstücke als Scheiben flachseitig miteinander verbunden. Die Scheiben Stl und St2 definieren die voneinander verschiedene Kristallorientierungen für anisotropes Ätzen aufweisenden Bereiche B1 bzw. B2 aus einkristallinem Silizium des Körpers K.

Die Faser F ist in einer Nut VN1 mit V-förmigem Profil befestigt, die in der oberen Scheibe Stl durch anisotropes Ätzen des (100)-Siliziummaterials erzeugt worden ist. Dabei wird die Faser F in Querrichtung durch die Nut VN1 im Bereich ihrer Exzentritätstoleranzen (3-Sigma-Wert um 0,5 µm) bzw. ihrer Durchmessertoleranzen (3-Sigma-Wert 1,5 bis 1 µm) bei Monomodefasern mit 5 bis 10 µm Kerndurchmesser justiert.

Der Laserchip L wird in Längsrichtung durch die Lage der Faser F positioniert, in Querrichtung und in der Tiefe durch eine Vertiefung Ve mit vertikalen Wänden in der unteren Scheibe St2 aus dem (110)-Siliziummaterial. Die Vertiefung Ve wird durch anisotropes Ätzen hergestellt, indem zunächst in die obere Scheibe St1 ein Fenster OF mit durch schräge Flanken definiertem Rand erzeugt wird, und dann der in dem Fenster OF freiliegende Teil der unteren Scheibe St2 in die Tiefe geätzt wird.

Der Monitordetektor MD in Form eines Chip ist vorteilhafterweise auf einer Flanke F1 einer in Querrichtung des Laserchips L verlaufenden Nut VN3 mit V-förmigem Profil montiert, die in der oberen Scheibe St1 durch anisotropes Ätzen erzeugt worden ist.

Eine auf die gleiche Weise erzeugte weitere Nut VN2 mit V-förmigem Profil in der oberen Scheibe St1, die das Fenster OF mit der Nut VN3 verbindet, stellt sicher, daß vom Laserchip L in Richtung Detektor MD abgestrahltes Licht auf dessen Detektorfenster DF gelangt.

Der Körper ist auch für andere Aufgaben der Mikrostrukturtechnik in Silizium, wie z.B. Sensoren, anwendbar. Dabei können Körper mit mehr als zwei Kristallorientierungen und auch schräg orientierte Kristalle eingesetzt werden.

Auch können vorteilhafterweise Ätzstoppschichten, wie z.B. Dotierungssprünge, an gewünschter Stelle in einem solchen Körper ausgebildet sein.

## Patentansprüche

1. Verfahren zur Herstellung eines Körpers (K) aus kristallinem Silizium mit einer Vertiefung (Ve) und mit einer Nut (VN1) mit v-förmigem Profil, die in dieser Vertiefung (Ve) mündet,
bei dem dieser Körper durch flachseitiges Verbinden zweier Scheiben aus einkristallinem Silizium unterschiedlicher Kristallorientierungen zusammengesetzt wird, wobei diese Kristallorientierungen so ausgerichtet sind, daß nachfolgend sowohl diese Nut (VN1) als auch diese Vertiefung (Ve) mittels anisotropen Ätzens hergestellt werden können,
bei dem diese Nut (VN1) durch anisotropes Ätzen in einer dieser Scheiben (St1) hergestellt wird und
bei dem diese Vertiefung (Ve) hergestellt wird, indem mittels anisotropen Ätzens in dieser Scheibe (St1) zunächst ein Fenster (OF) mit durch schräge Flanken definiertem Rand hergestellt wird und dann das anisotrope Ätzen in die andere Scheibe (St2) derart fortgesetzt wird, daß die Vertiefung (Ve) mit bezüglich der Verbindungsfläche der Scheiben (St1, St2) vertikalen Wänden ausgebildet wird.

2. Verfahren nach Anspruch 1,
bei dem zwei einkristalline Scheiben (St1, St2) verschiedener Kristallorientierungen durch ein siliziumkompatibles Glaslot miteinander verbunden werden.

3. Verfahren nach Anspruch 2,
bei dem das Glaslot mit Phosphor dotiertes SiO₂ ist.

4. Verfahren nach Anspruch 1,
bei dem zwei einkristalline Scheiben (St1, St2) unterschiedlicher Kristallorientierungen mit einem Silizium-Gold-Eutektikum durch eine Metallottechnik miteinander verbunden werden.

## Claims

1. Method of manufacturing a body (K) made of crystalline silicon having a recess (Ve) and having a groove (VN1) with a v-shaped profile which opens into the said recess (Ve), in which method the said body is assembled by flat-sided joining of two wafers of monocrystalline silicon having different crystal orientations, the said crystal orientations being aligned in such a way that both the said groove (VN1) and the said recess (Ve) can subsequently be manufactured by means of anisotropic etching, in which method the said groove (VN1) is manufactured in one of the said wafers (St1) by anisotropic etching, and in which method the said recess (Ve) is manufactured by first making a window (OF) having a periphery defined by inclined edges in the said wafer (Stl) by anisotropic etching and then continuing the anisotropic etching in the other wafer (St2) in such a way that the recess (Ve) is formed with vertical walls with respect to the joining surface of the wafers (St1, St2).

2. Method according to Claim 1, in which two monocrystalline wafers (St1, St2) having different crystal orientations are joined together by a silicon compatible glass solder.

3. Method according to Claim 2, in which the glass solder is SiO₂ doped with phosphorus.

4. Method according to Claim 1, in which two monocrystalline wafers (St1, St2) having different crystal orientations are joined together by a metal solder technique using a silicon/gold eutectic.

## Revendications

1. Procédé de fabrication d' un corps (K) en silicium cristallin, ayant une cavité (Ve) et une gorge (VN1) à profil en forme de v, qui débouche dans cette cavité (Ve),
dans lequel ce corps est assemblé par liaison par leurs faces planes de deux pastilles en silicium monocristallin d'orientations cristallines différentes, ces orientations cristallines étant dirigées de sorte qu'ensuite, tant cette gorge (VN1) que cette cavité (Ve) peuvent être obtenues au moyen d'une gravure anisotrope,
dans lequel cette gorge (VN1) est obtenue par gravure anisotrope de l'une de ses pastilles (St1), et
dans lequel cette cavité (Ve) est obtenue en ménageant d'abord, au moyen d'une gravure anisotrope de cette pastille (St1), une fenêtre (OF) à bord défini par des flancs inclinés, puis en poursuivant la gravure anisotrope dans l'autre pastille (St2), de façon que la cavité (Ve) ait des parois verticales par rapport à la surface de liaison des pastilles (St1, St2).

2. Procédé suivant la revendication 1,
dans lequel deux pastilles (St1, St2) monocristallines d'orientations cristallines différentes sont reliées entre elles par du verre de soudure compatible avec du silicium.

3. Procédé suivant la revendication 2,
caractérisé en ce que le verre de soudure est du SiO₂ dopé au phosphore.

4. Procédé suivant la revendication 1,
dans lequel deux pastilles (St1, St2) monocristallines d'orientations cristallines différentes sont reliées entre elles par un eutectique silicium-or, au moyen d'une technique de métallosoudure.
